# EUROPÄISCHE PATENTSCHRIFT

(11) **EP 2 678 931 B1**
(45) Veröffentlichungstag und Bekanntmachung des Hinweises auf die Patenterteilung: **04.11.2015**
(21) Anmeldenummer: 12712084.8
(22) Anmeldetag: 14.03.2012
(51) Int. Cl.: H02M 7/483

(54) **MODULARER MEHRFACHUMRICHTER MIT RÜCKWÄRTS LEITFÄHIGEN LEISTUNGSHALBLEITERSCHALTERN**
MODULAR MULTIPLE CONVERTER COMPRISING REVERSE CONDUCTIVE POWER SEMICONDUCTOR SWITCHES
CONVERTISSEUR MODULAIRE À ÉTAPES MULTIPLES, AYANT DES COMMUTATEURS SEMI-CONDUCTEURS DE PUISSANCE CONDUCTEURS EN SENS INVERSE

(30) Priorität: 29.03.2011 DE 102011006345
(43) Veröffentlichungstag der Anmeldung: 01.01.2014
(73) Patentinhaber: Siemens Aktiengesellschaft, 80333 München (DE)
(72) Erfinder: ECKEL, Hans-Günter, 18059 Rostock (DE)
(86) Internationale Anmeldenummer: PCT/EP2012/054462
(87) Internationale Veröffentlichungsnummer: WO 2012/130615

(56) Entgegenhaltungen:
- DE-A1- 10 103 031
- RAINER MARQUARDT ET AL: "Modulares Stromrichterkonzept für Netzkupplungsanwendungen bei hohen Spannungen", BAUELEMENTE DER LEISTUNGSELEKTRONIK UND IHRE ANWENDUNGEN: VORTRÄGE DER ETG-FACHTAGUNG, 23-24 APRIL 2002, BAD NAUHEIM, KURHAUS, VDE-VERLAG, BERLIN, 1. Januar 2002 (2002-01-01), Seiten 155-161, XP008105719, ISBN: 978-3-8007-2690-5

## Beschreibung

Die Erfindung betrifft ein Submodul für einen modularen Mehrstufenumrichter mit wenigstens einem unipolaren Energiespeicher, einer ersten und einer zweiten Anschlussklemme und einer Leistungshalbleiterschaltung, die mittels eines Steuersignals ein- und abschaltbare Leistungshalbleiterschalter und Freilaufdioden aufweist, die einem zugeordneten Leistungshalbleiterschalter gegensinnig parallel geschaltet sind, wobei je nach Ansteuerung der Leistungshalbleiterschalter die an einem oder allen Energiespeichern abfallende Spannung oder aber eine Nullspannung zwischen der ersten und der zweiten Anschlussklemme erzeugbar ist und wobei die Leistungshalbleiterschaltung einen Überbrückungszweig ausbildet, der zwischen den Potenzialpunkten der ersten und zweiten Anschlussklemme liegt.

Ein solches Submodul ist beispielsweise aus der DE 101 03 031 oder dem Aufsatz "Modulares Stromrichterkonzept für Netzkopplungsanwendungen bei hohen Spannungen", Marquardt et al, ETG-Fachtagung 2002, bereits bekannt. Dort ist ein Mehrstufenumrichter offenbart, der Phasenmodule aufweist, die jeweils einen Wechselspannungsanschluss für eine Phase eines anzuschließenden Wechselspannungsnetzes sowie zwei Gleichspannungsanschlüsse aufweisen, die zum Anschluss eines Gleichspannungszwischenkreises vorgesehen sind. Zwischen dem Wechselspannungsanschluss und jedem Gleichspannungsanschluss erstreckt sich ein Phasenmodulzweig. Die beiden Phasenmodulzweige eines Phasenmoduls sind mit den restlichen Phasenmodulzweigen wie eine so genannte "Graetzbrücke" verschaltet. Dabei weist jeder Phasenmodulzweig eine Reihenschaltung aus Submodulen auf, die jeweils mit einem unipolaren Speicherkondensator ausgerüstet sind. Dem Speicherkondensator ist eine Reihenschaltung aus zwei ein- und abschaltbaren Leistungshalbleiterschaltern parallel geschaltet, denen jeweils eine Freilaufdiode gegensinnig parallel geschaltet ist. In der Reihenschaltung sind die besagten ansteuerbaren Leistungshalbleiterschalter mit gleicher Durchlassrichtung angeordnet. Das vorbekannte Submodul weist ferner zwei Anschlussklemmen auf, wobei eine Anschlussklemme direkt mit einem Pol des Speicherkondensators und die andere Anschlussklemme mit dem Potenzialpunkt verbunden ist, der zwischen den beiden ansteuerbaren Leistungshalbleiterschaltern liegt. Je nach Ansteuerung der Leistungshalbleiterschalter kann somit entweder die an dem Speicherkondensator abfallende Kondensatorspannung oder aber eine Nullspannung an die beiden Anschlussklemmen eines jeden Submoduls angelegt werden. Aufgrund der Reihenschaltung kann die Gesamtspannung eines jeden Phasenmodulzweiges stufenweise eingestellt werden, wobei die Höhe der Stufen durch die an dem Speicherkondensator abfallende Spannung festgelegt ist.

Aus der Praxis sind ferner ansteuerbare ein- und abschaltbare Leistungshalbleiter bekannt, die rückwärts leitfähig sind. Diese Leistungshalbleiterschalter benötigen daher keine gegensinnig parallel geschaltete Freilaufdiode mehr. Rückwärts leitfähige Leistungshalbleiterschalter weisen gegenüber den nicht rückwärts leitfähigen Leistungshalbleiterschaltern den Vorteil auf, dass an diesen bei Normalbetrieb eine geringere Durchlassspannung abfällt, so dass die Verluste gegenüber nicht rückwärts leitfähigen Leistungshalbleiterschaltern verringert sind. Den rückwärts leitfähigen Leistungshalbleiterschaltern haftet jedoch der Nachteil an, dass diese im Vergleich zu den bereits markterhältlichen Leistungshalbleiterschaltern ohne Rückleitfähigkeit teuer sind.

Aufgabe der Erfindung ist es daher, ein Submodul der eingangs genannten Art bereitzustellen, das bei Normalbetrieb geringere Verluste aufweist und darüber hinaus auch kostengünstig ist.

Die Erfindung löst diese Aufgabe dadurch, dass nur die in dem Überbrückungszweig angeordneten Leistungshalbleiterschalter rückwärts leitfähige Leistungshalbleiterschalter sind, die sowohl mittels eines Ansteuersignals in ihrer Durchgangsrichtung ein- und abschaltbar als auch entgegen ihrer schaltbaren Durchgangsrichtung leitfähig sind.

Im Rahmen der Erfindung ist ein Submodul für einen modularen Mehrstufenumrichter bereitgestellt, das rückwärts leitfähige Leistungshalbleiterschalter aufweist. Da sowohl Submodule der eingangs genannten Art, als auch rückwärts leitfähige Leistungshalbleiterschalter bekannt sind, wäre der vollständige Ersatz der bislang verwendeten nicht rückwärts leitfähigen Leistungshalbleiterschalter durch rückwärts leitende Leistungshalbleiterschalter naheliegend. Ein solches Submodul wäre dann in jedem Falle durch geringere Durchlassspannungen und somit weniger hohe Betriebsverlusten als vorbekannte Submodul gekennzeichnet. Erfindungsgemäß wurde jedoch erkannt, dass Leistungshalbleiterschalter, die zwischen den Anschlussklemmen angeordnet sind, höher belastet werden, als nicht zwischen den Anschlussklemmen angeordnete Leistungshalbleiterschalter. Diese Erkenntnis ist Ausfluss komplexer Berechnungen und Simulationen, die nicht Gegenstand der vorliegenden Erfindung sein sollen. Aufgrund dieser Erkenntnis sind im Rahmen der Erfindung die rückwärts leitfähigen ansteuerbaren ein- und abschaltbaren Leistungshalbleiterschalter ausschließlich in dem Überbrückungszweig des Submoduls angeordnet, das zwischen den Potenzialpunkten der Anschlussklemmen liegt. Dies sind somit die Leistungshalbleiterschalter, die bei Normalbetrieb des Submoduls insbesondere bei Anwendungen im Bereich der Energieübertragung und -verteilung besonders stark belastet sind. Durch den Einsatz rückwärts leitfähiger ein- und abschaltbarer Leistungshalbleiterschalter kann die Durchlassspannung herabgesetzt werden. Die weniger stark belasteten Leistungshalbleiterschalter sind im Rahmen der Erfindung weiterhin Leistungshalbleiterschalter, die keine Rückwärtsleitfähigkeit aufweisen und denen somit, wie aus dem Stand der Technik bekannt, Freilaufdioden gegensinnig parallel geschaltet sind. Diese Leistungshalbleiterschalter sind wesentlich kostengünstiger erhältlich. Da die kostengünstigeren Leistungshalbleiterschalter nur an weniger stark belasteten Stellen des Submoduls eingesetzt sind, sind die Verluste, die aufgrund einer erhöhten Durchlassspannung entstehen, hinnehmbar.

Gemäß einer bevorzugten Ausgestaltung der Erfindung ist ein unipolarer Energiespeicher vorgesehen, dem eine Reihenschaltung aus ansteuerbaren ein- und abschaltbaren Leistungshalbleiterschaltern mit gleicher Durchlassrichtung parallel geschaltet ist, wobei die erste Anschlussklemme mit einem ersten Pol des Energiespeichers und die zweite Anschlussklemme mit einem zwischen den ansteuerbaren Leistungshalbleiterschaltern liegenden Potenzialpunkt verbunden ist. Die Schaltung eines solchen Submoduls ist grundsätzlich bekannt, wobei jedoch der hoch belastete Leistungshalbleiterschalter erfindungsgemäß ein rückwärts leitfähiger Leistungshalbleiterschalter ist. Dieser Leistungshalbleiterschalter ist während des Betriebs höher belastet, so dass der Einsatz nur eines rückwärts leitfähigen Leistungshalbleiterschalters im Überbrückungszweig zwischen den Anschlussklemmen bereits ausreichend ist, um die Betriebsverluste herabzusetzen. Der nicht zwischen den Anschlussklemmen liegende Leistungshalbleiterschalter ist, wie im Stand der Technik, ein nicht rückwärts leitfähiger Leistungshalbleiterschalter, dem eine Freilaufdiode gegensinnig parallel geschaltet ist.

Abweichend hiervon sind gemäß einer weiteren Variante der Erfindung ein erster und ein in Reihe zum ersten Energiespeicher geschalteter zweiter Energiespeicher vorgesehen und in dem Überbrückungszweig zwei rückwärts leitfähige Leistungshalbleiterschalter mit gleicher Durchlassrichtung angeordnet, wobei der Potenzialpunkt zwischen den rückwärts leitfähigen Leistungshalbleiterschaltern mit dem Potenzialpunkt zwischen dem ersten und dem zweiten Energiespeicher verbunden ist und wobei der Überbrückungszweig über einen ersten Leistungshalbleiterschalter mit gegensinniger erster Freilaufdiode mit einem Pol des zweiten Energiespeichers und über einen zweiten Leistungshalbleiterschalter mit gegensinniger Freilaufdiode mit einem Pol des ersten Energiespeichers verbunden ist, so dass der Überbrückungszweig zwischen die nicht rückwärts leitfähigen Leistungshalbleiterschalter geschaltet ist und wobei alle Leistungshalbleiterschalter in Reihe und mit gleicher Durchlassrichtung angeordnet sind. Gemäß dieser vorteilhaften Weiterentwicklung ist ein Doppelmodul bereitgestellt, das als solches ebenfalls bekannt ist. Bei dem besagten Doppelmodul sind im Rahmen der Erfindung nur die zwischen Anschlussklemmen liegenden Leistungshalbleiterschalter als rückwärts leitfähige Leistungshalbleiterschalter ausgewählt, da diese Leistungshalbleiterschalter beim Betrieb eines Mehrstufenumrichters höher belastet sind als die nicht zwischen den Anschlussklemmen liegenden Leistungshalbleiterschalter.

Gemäß einer bevorzugten Ausgestaltung der Erfindung ist jeder rückwärts leitfähige Leistungshalbleiterschalter so beschaffen, dass an diesem eine möglichst geringe Durchlassspannung abfällt. Rückwärts leitfähige Leistungshalbleiterschalter, beispielsweise rückwärts leitfähige Insulated Gate Bipolar Transistors (IGBT), lassen sich auf unterschiedliche Weise optimieren. Hierbei liegt eine Wechselwirkung zwischen der so genannten "Reverse-Recovery-Ladung" im Diodenmodus auf der einen Seite und der Durchlassspannung sowohl im Dioden- als auch im Leistungshalbleiterschaltmodus auf der anderen Seite vor. So führt eine niedrige Reverse-Recovery-Ladung zu höheren Durchlassspannungen sowohl im IGBT als auch im Diodenmodus. Die Optimierung des rückwärts leitfähigen IGBT kann daher entweder zu niedrigeren Durchlassverlusten oder aber zu niedrigen Schaltverlusten führen. Gemäß dieser vorteilhaften Weiterentwicklung sind die rückwärts leitfähigen Leistungshalbleiterschalter für niedrige Durchlassspannungen optimiert.

Zweckmäßigerweise ist eine Ansteuereinheit zum Ansteuern der ansteuerbaren Leistungshalbleiterschalter vorgesehen, wobei die Ansteuereinheit so eingerichtet ist, dass die nicht rückwärts leitfähigen Leistungshalbleiterschalter im Vergleich zu allen rückwärts leitfähigen ansteuerbaren Leistungshalbleiterschaltern langsamer eingeschaltet werden. Ist der oder sind die zwischen den Anschlussklemmen angeordneten Leistungshalbleiterschalter auf geringe Durchlassspannungen hin optimiert, ergeben sich hohe Speicherladungen, wenn der rückwärts leitfähige Leistungshalbleiterschalter als Diode wirkt, also einen Strom entgegen seiner schaltbaren Durchlassrichtung führt. Die hohen Speicherladungen der rückwärts leitenden Leistungshalbleiterschalter führen jedoch bei dem oder den in Reihe geschalteten nicht rückwärts leitfähigen Leistungshalbleiterschaltern zwar zu hohen Einschaltverlusten. Die hohen Einschaltverluste sind bei den weniger stark belasteten Leistungshalbleiterschaltern, die nicht im Überbrückungszweig angeordnet sind jedoch weniger störend, da diese Leistungshalbleiterschalter, wie im Rahmen der Erfindung erkannt wurde, weniger stark belastet sind. Durch das langsamere Einschalten werden die hohen Einschaltströme begrenzt, so dass die Gefahr einer Zerstörung dieser Leistungshalbleiterschalter herabgesetzt ist.

Gemäß einer weiteren zweckmäßigen Weiterentwicklung sind die nicht im Überbrückungszweig angeordneten Leistungshalbleiterschalter dahin optimiert, dass diese eine möglichst geringe Speicherladung aufweisen. Die niedrige Speicherladung minimiert wiederum die Einschaltverluste in den in Reihe geschalteten Leistungshalbleiterschaltern des Überbrückungszweigs, die rückwärts leitfähig und besonders hoch belastet sind. Auf diese Art und Weise sind die Einschaltverluste der hoch belasteten rückwärts leitfähigen Leistungshalbleiterschalter minimiert. Die höheren Durchlassverluste der weniger stark belasteten Leistungshalbleiterschalter sind weniger störend.

Zweckmäßigerweise ist eine Ansteuereinheit zum Ansteuern der ansteuerbaren Leistungshalbleiterschalter vorgesehen, wobei die Ansteuereinheit so eingerichtet ist, dass die nicht rückwärts leitfähigen Leistungshalbleiterschalter im Vergleich zu dem rückwärts leitfähigen ansteuerbaren Leistungshalbleiterschalter langsamer eingeschaltet werden. Dies reduziert die Verluste, die bei den rückwärts leitfähigen Leistungshalbleiterschaltern im Diodenmodus aufgrund der hohen Speicherladungen entsteht, auf Kosten der Einschaltverluste der nicht rückwärts leitfähigen Leistungshalbleiterschalter. Dies ist vorteilhaft, da letztere weniger stark belastet sind.

Die Erfindung betrifft auch einen Mehrstufenumrichter mit einem Submodul gemäß einem der vorhergehenden Ansprüche.

Weitere zweckmäßige Ausgestaltungen und Vorteile der Erfindung sind Gegenstand der nachfolgenden Beschreibung von Ausführungsbeispielen der Erfindung unter Bezug auf die Figuren der Zeichnungen, wobei gleiche Bezugszeichen auf gleich wirkende Bauteile verweisen und wobei
- Figur 1: ein Ausführungsbeispiel des erfindungsgemäßen Mehrstufenumrichters,
- Figur 2: ein Submodul gemäß dem Stand der Technik,
- Figur 3: ein Substrat eines IGBTs als Leistungshalbleiterschalter mit parallel geschalteter gegensinniger Freilaufdiode,
- Figur 4: ein Substrat eines rückwärts leitfähigen Leistungshalbleiterschalters,
- Figur 5: ein Submodul gemäß Figur 2, das ausschließlich rückwärts leitfähige Leistungshalbleiterschalter aufweist,
- Figur 6: ein Ausführungsbeispiel des erfindungsgemäßen Submoduls,
- Figur 7: ein weiteres Ausführungsbeispiel des erfindungsgemäßen Submoduls,
- Figur 8: das Submodul gemäß Figur 7 mit Überbrückungsschaltern und
- Figur 9: ein weiteres Ausführungsbeispiel des erfindungsgemäßen Submoduls zeigen.

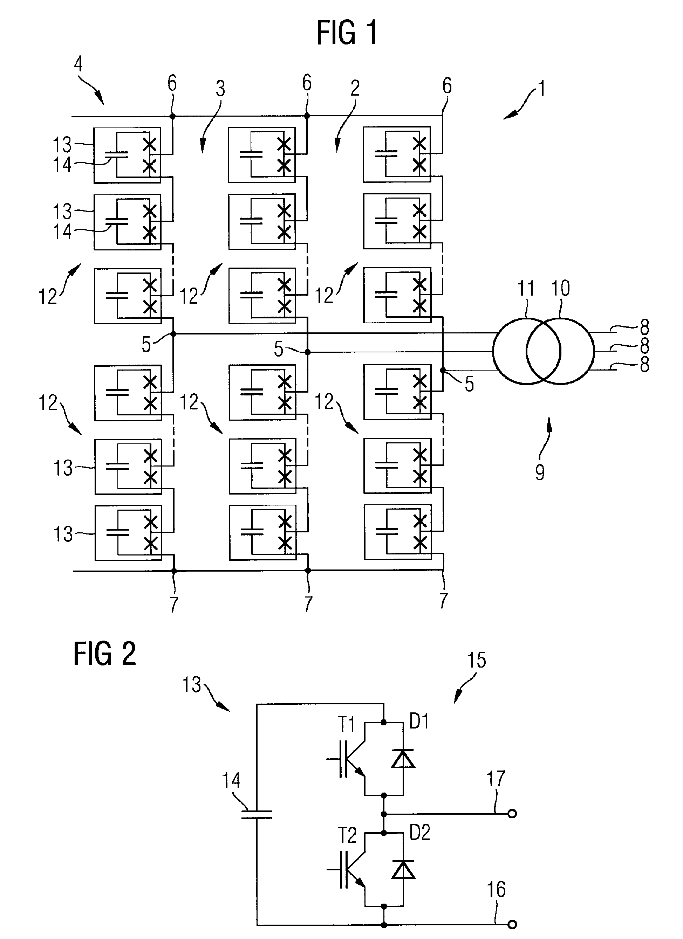

Figur 1 zeigt ein Ausführungsbeispiel des erfindungsgemäßen Mehrstufenumrichters in einer schematischen Darstellung. Es ist erkennbar, dass der Mehrstufenumrichter drei Phasenmodule 2, 3 und 4 aufweist, wobei jedes der Phasenmodule 2, 3, 4 einen Wechselspannungsanschluss 5 sowie zwei Gleichspannungsanschlüsse 6 und 7 aufweist. Jeder Wechselspannungsanschluss 5 ist mit einer Phase 8 eines figürlich nicht dargestellten Wechselspannungsnetzes verbunden. Zur galvanischen Trennung zwischen dem Umrichter 1 und dem Wechselspannungsnetz dient ein Transformator 9 mit einer Primärwicklung 10 und einer Sekundärwicklung 11. Zwischen dem Wechselspannungsanschluss 5 und jedem der Gleichspannungsanschlüsse 6 und 7 bildet jedes der Phasenmodule 2, 3 und 4 zwei Phasenmodulzweige 12 aus. Die Phasenmodulzweige aller Phasenmodule 2, 3, 4 sind miteinander zu einer Brückenschaltung verschaltet. Dabei verfügt jeder Phasenmodulzweig über eine Reihenschaltung aus Submodulen 13, die jeweils mit einem oder mehreren unipolaren Kondensatoren 14 als Energiespeicher ausgestattet sind.

Figur 2 zeigt die Ausgestaltung eines Submoduls gemäß dem Stand der Technik. Es ist erkennbar, dass das Submodul einen unipolaren Kondensator 14 aufweist, dem eine Reihenschaltung 15 parallel geschaltet ist, in der zwei mittels eines Ansteuersignals ein- und abschaltbare Leistungshalbleiterschalter T1 und T2 in Reihe geschaltet sind. Die besagten Leistungshalbleiterschalter T1 und T2 sind rückwärts nicht leitfähig, so dass ihnen jeweils eine Freilaufdiode D1 beziehungsweise D2 gegensinnig parallel geschaltet ist. Der Potenzialpunkt zwischen den ansteuerbaren Leistungshalbleiterschaltern T1 und T2 beziehungsweise zwischen den Freilaufdioden D1 und D2 ist mit einer zweiten Anschlussklemme 17 verbunden, wobei ein Pol des Speicherkondensator 14 mit einer ersten Anschlussklemme 16 verbunden ist. Bei den Leistungshalbleiterschaltern T1 und T2 handelt es sich im gezeigten Beispiel um einen so genannten IGBT, wobei jedoch auch andere ein- und abschaltbare Leistungshalbleiterschalter, wie beispielsweise GTO, IGCTs oder dergleichen, verwendet werden können.

Wird der Leistungshalbleiterschalter T1 in seine Durchgangsstellung überführt, in welcher ein Stromfluss über T1 in der angezeigten Durchgangsrichtung ermöglicht ist, muss der Leistungshalbleiterschalter T2 in seine Sperrstellung überführt sein, um einen Kurzschluss des Speicherkondensators 14 vermeiden. Entsprechendes gilt im umgekehrten Fall. Ist also der Leistungshalbleiterschalter T1 in seine Durchgangsstellung geschaltet, ist der Leistungshalbleiterschalter T2 in eine Sperrstellung überführt, so dass an den Anschlussklemmen 16 und 17 die Kondensatorspannung U_{c} des Speicherkondensators 14 abfällt. Im umgekehrten Falle ist die erste Anschlussklemme 16 über den abschaltbaren Leistungshalbleiterschalter T2 mit der ersten Anschlussklemme verbunden, so dass eine Nullspannung an den Anschlussklemmen 16, 17 abfällt. Bei einem in Figur 1 gezeigten Phasenmodulzweig 12, der beispielsweise Submodule 13 gemäß Figur 2 in Reihenschaltung aufweist, kann somit die Spannung, die an dem gesamten Phasenmodulzweig 12 abfällt, stufenweise erhöht und erniedrigt werden, wobei die Höhe der Stufen durch die Höhe der Kondensatorspannung U_{c} festgelegt ist. Diese richtet sich selbstverständlich nach der Sperrfähigkeit der Leistungshalbleiterschalter T1 beziehungsweise T2. Diese liegt gemäß dem derzeitigen Stand der Technik zwischen 1 kV und 10 kV. Bei Hochspannungsanwendungen werden somit mehrere hundert Submodule 12 in Reihe geschaltet. Alternativ dazu können die Leistungshalbleiterschalter T1 und T2 auch für eine Reihenschaltung von Leistungshalbleiterschaltern stehen, so dass die Sperrspannung der Schalter und somit die Höhe der Spannungsstufen erhöht ist.

Aus dem Stand der Technik sind darüber hinaus rückwärts leitfähige Leistungshalbleiterschalter bekannt, die sowohl mittels eines Ansteuersignals in ihrer Durchgangsrichtung ein- und abschaltbar als auch entgegen ihrer schaltbaren Durchgangsrichtung leitfähig sind. Mit anderen Worten kann ein Stromfluss in Durchgangsrichtung unterbrochen werden, wenn der rückwärts leitfähige Leistungshalbleiterschalter in seine Sperrstellung überführt wird. Der Stromfluss über den rückwärts leitfähigen Leistungshalbleiterschalter in Durchgangsrichtung kann dann nur ermöglicht werden, wenn dieser von seiner Sperrstellung in seine Durchgangsstellung aktiv mittels eines Steuersignals überführt wird. Für einen Strom, der in einer Richtung entgegensetzt zur Durchlassrichtung fließt, bleibt der rückwärts leitfähige Leistungshalbleiter unabhängig von dem anliegenden Steuersignal immer leitfähig. Für diese Stromrichtung wirkt der Leistungshalbleiter daher wie eine Diode. Durch die Rückleitfähigkeit ist das Parallelschalten einer gegensinnigen Diode unnötig geworden.

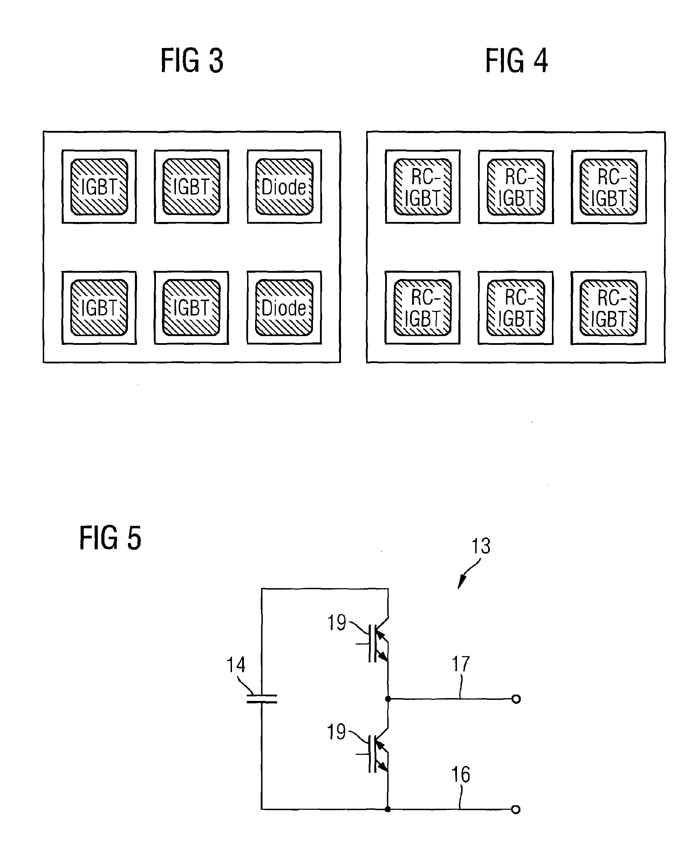

Figur 3 zeigt ein Substrat eines nicht rückwärts leitfähigen IGBTs mit gegensinnig geschalteter Freilaufdiode. Es ist erkennbar, dass für den ein- und abschaltbaren IGBT auf einem Substrat vier Halbleiterchips angeordnet sind, wobei für die Diode zwei Chips vorgesehen sind.

Figur 4 zeigt ein Substrat eines rückwärts leitfähigen IGBTs, der dort mit RC-IGBT bezeichnet ist. Es ist erkennbar, dass auf einem Substrat sechs RC-IGBT-Chips angeordnet sind. Sowohl in der Durchlass- aber auch in der entgegen gesetzten "Dioden"-Richtung werden beim rückwärts leitfähigen IGBT somit sämtliche Chips verwendet. Bei einem nicht rückwärts leitfähigen IGBT, wie er in Figur 3 schematisch dargestellt ist, werden hingegen nur vier Chips in Durchgangsrichtung beziehungsweise zwei Chips in der Diodenbetriebsart ausgenutzt. Somit verteilt sich bei einem rückwärts leitfähigen IGBT der Stromfluss in beiden Richtungen auf mehr Halbleiterchips. Schon aus diesem Grunde weist der rückwärts leitfähige IGBT eine geringere Durchgangsspannung auf als ein entsprechend ausgelegter Leistungshalbleiterschalter ohne Rückwärtsleitfähigkeit. Es ist daher naheliegend, ein Submodul gemäß Figur 2 ausschließlich mit rückwärts leitfähigen IGBTs 19 zu bestücken, wie dies in Figur 5 dargestellt ist.

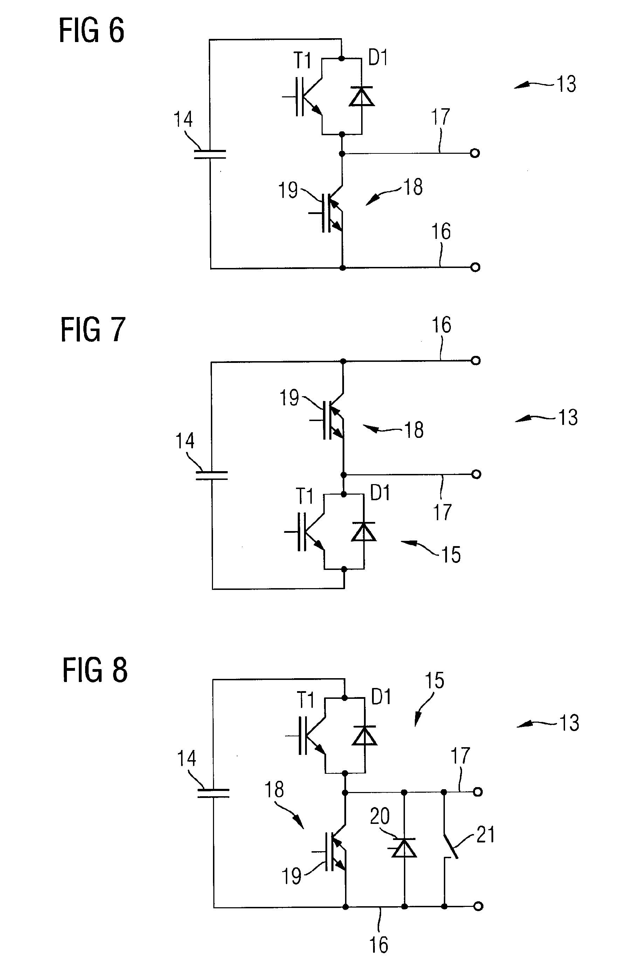

Figur 6 zeigt ein Ausführungsbeispiel gemäß der vorliegenden Erfindung. Es ist im Vergleich mit Figur 2 erkennbar, dass in dem sich zwischen den Anschlussklemmen 16 und 17 erstreckenden Übergangszweig 18 ein rückwärts leitfähiger Leistungshalbleiterschalter 19 angeordnet ist. Außerhalb des Übergangszweigs 18 ist jedoch ein nicht rückwärts leitfähiger IGBT T1 vorgesehen, dem wiederum eine Diode D1 gegensinnig parallel geschaltet ist. Im Vergleich zu dem in Figur 5 dargestellten Submodul ist das Submodul gemäß Figur 6 somit wesentlich kostengünstiger. Durch aufwändige Berechnungen konnte herausgebracht werden, dass insbesondere bei Anwendungen im Bereich der Energieübertragung der im Überbrückungszweig 18 angeordnete Leistungshalbleiterschalter T2 beziehungsweise 19 stärker beansprucht wird als der Leistungshalbleiterschalter T1. Somit ist es erfindungsgemäß völlig ausreichend, den teureren rückwärts leitfähigen IGBT lediglich im Überbrückungszweig 18 nicht jedoch außerhalb des Überbrückungszweiges 18 anzuordnen.

Der rückwärts leitfähige IGBT 19 kann nun in zwei Richtungen optimiert werden. Zum einen kann er so eingestellt werden, dass an ihm eine geringere Durchlassspannung abfällt. Die Durchlassspannung ist die Spannung, die an dem Leistungshalbleiterschalter 19 für beide Stromrichtungen abfällt. Eine niedrige Durchlassspannung hat geringere Verluste im Gefolge. Wird der rückwärts leitfähige IGBT jedoch dahin optimiert, dass er sowohl in IGBT- als auch im Diodenmodus geringe Durchlassspannungen aufweist, geht dies aus physikalischen Gründen nur auf Kosten hoher Reverse-Recovery-Ladungen. Eine hohe Reverse-Recovery-Ladung hat jedoch hohe Einschaltverluste im Gefolge.

Fließt in Figur 6 nun ein Strom von der ersten Anschlussklemme 16 über den rückwärts leitfähigen IGBT 19 im Diodenmodus zur Anschlussklemme 17, kann es aufgrund der hohen Reverse-Recovery-Ladungen des rückwärts leitfähigen IGBTs 19 dazu kommen, dass beim Einschalten von T1, also beim Überführen des nicht rückwärts leitfähigen Leistungshalbleiterschalters T1 von seiner Sperr- in seine Durchgangsstellung ein so hoher Strom über T1 fließt, dass dieser zerstört wird. Deswegen ist dieser im Rahmen eines Ausführungsbeispiels der Erfindung mit einer Regelungseinheit verbunden, die über den Gateanschluss des T1 für ein gegenüber dem Abschaltvorgang des IGBT langsameres Einschalten von T1 sorgt. Auf diese Weise ist eine Zerstörung von T1 verhindert. Da der nicht rückwärts leitfähige Leistungshalbleiterschalter T1 weniger stark belastet ist als der rückwärts leitfähige Leistungshalbleiterschalter 19, hat dieser noch thermische Reserven, so dass die hohen Einschaltverluste mit einer Wärmeentwicklung im Gefolge hinnehmbar sind. Wird bei einem Stromfluss von der Anschlussklemme 17 über den rückwärts leitfähigen Leistungshalbleiterschalter 19 zur Anschlussklemme 16 der Leistungshalbleiterschalter 19 in seine Sperrstellung überführt, kommt es zwar zu hohen Abschaltverlusten, diese sind jedoch im Hinblick auf geringere Durchlassverluste hinnehmbar.

Figur 7 zeigt ein weiteres Ausführungsbeispiel der Erfindung. Es ist erkennbar, dass im Vergleich zu Figur 6 die erste Anschlussklemme 16 mit einem abweichenden Pol des unipolaren Speicherkondensators 14 verbunden ist. Wieder ist im Überbrückungszweig 18 ein rückwärts leitfähiger IGBT angeordnet, während der Leistungshalbleiterschalter, der nicht zwischen den Anschlussklemmen 16 und 17 liegt, wieder ein nicht rückwärts leitfähiger IGBT mit gegensinnig paralleler Freilaufdiode D1 angeordnet ist.

Figur 8 zeigt das Ausführungsbeispiel der Erfindung gemäß Figur 6, wobei jedoch das Submodul 13 mit einem Thyristor 20 beziehungsweise einem mechanischen Schalter 21 überbrückbar ist. Dies ist im Fehlerfall erforderlich, um das fehlerhafte Submodul im Phasenmodulzweig 12 überbrücken zu können, so dass der Betrieb des Umrichters fortgesetzt werden kann.

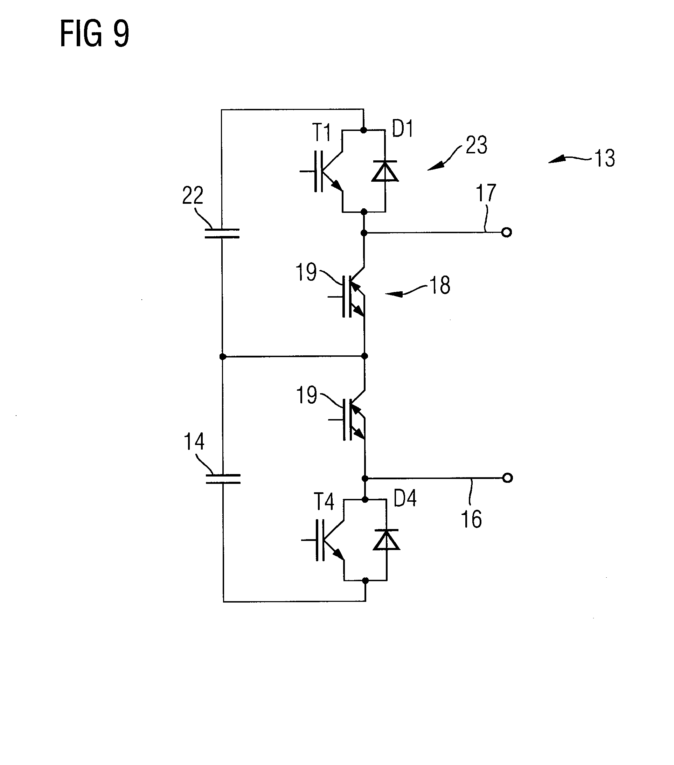

Figur 9 zeigt ein weiteres Ausführungsbeispiel des erfindungsgemäßen Submoduls 13, das auch als Doppelmodul bezeichnet werden kann. Im Gegensatz zu den bislang vorgestellten Submodulen 13 weist das in Figur 9 gezeigte Submodul 13 eine Reihenschaltung aus zwei Speicherkondensatoren 14 und 22 auf. Der Reihenschaltung aus Speicherkondensatoren 14 und 22 ist eine Reihenschaltung aus Leistungshalbleiterschaltern 23 parallel geschaltet. In die Reihenschaltung 23 integriert ist der Überbrückungszweig 18. Der Überbrückungszweig 18 liegt zwischen den Potenzialpunkten der ersten 16 und der zweiten Anschlussklemme 17. Im Überbrückungszweig 18 sind zwei rückwärts leitfähige mittels Steuersignal ein- und abschaltbare rückwärts leitfähige Leistungshalbleiterschalter 19 angeordnet. Der Potenzialpunkt zwischen den besagten Leistungshalbleiterschaltern 19 ist mit dem Potenzialpunkt zwischen den Speicherkondensatoren 14 und 22 verbunden. Der Kollektor des ersten Leistungshalbleiterschalters T1 ist mit einer freien Klemme oder dem freien Pol des zweiten Speicherkondensators 22 verbunden. Diesem ersten nicht rückwärts leitfähigen Leistungshalbleiterschalter T1 ist wieder eine Freilaufdiode D1 gegensinnig parallel geschaltet. Ferner ist ein vierter Leistungshalbleiterschalter T4 vorgesehen, der den Überbrückungszweig 18 mit einem freien Pol oder einer Klemme des ersten Speicherkondensators 14 verbindet. Dazu ist der Emitter des nicht rückwärts leitfähigen Leistungshalbleiterschalters T4 mit der besagten Klemme vom Speicherkondensator 14 verbunden. Dem Leistungshalbleiterschalter T4 ist wiederum eine Freilaufdiode gegensinnig parallel geschaltet. Gemäß dieser Schaltung kann nun entweder die an dem Speicherkondensator 14 oder die an dem Speicherkondensator 22 abfallende Spannung an die Anschlussklemmen 16, 17 gelegt werden. Auch kann die Summenspannung, also die Summe der Spannung des Speicherkondensators 14 und der Spannung des Speicherkondensators 22, zwischen den Anschlussklemmen 16 und 17 erzeugt werden.

Die zweiten und dritten Leistungshalbleiterschalter 19 der Reihenschaltung 23 sind rückwärts leitfähige Leistungshalbleiterschalter 19. Beide sind wiederum für geringe Durchlassverluste ausgelegt und bilden eine vergleichsweise hohe Reverse-Recovery-Ladung aus. Um eine Zerstörung von T1 und T4 zu vermeiden, werden diese über eine nicht gezeigte Regelungseinheit im Vergleich zu den Schaltzeiten von dem rückwärts leitfähigen Leistungshalbleiterschalter 19 im Überbrückungszweig 18 langsam eingeschaltet. Im Übrigen gelten die Ausführungen zu dem Schalter gemäß Figur 6 hier entsprechend. Insbesondere sind die im Überbrückungszweig 18 angeordneten Schalter 19 höher belastet als die nicht im Überbrückungsschalter angeordneten Schalter T1 und T4.

## Patentansprüche

1. Submodul (13) für einen modularen Mehrstufenumrichter (1) mit
- wenigstens einem unipolaren Energiespeicher (14),
- einer ersten und einer zweiten Anschlussklemme (16,17) und
- einer Leistungshalbleiterschaltung, die mittels eines Steuersignals ein- und abschaltbare Leistungshalbleiterschalter (T1,T4,19) und Freilaufdioden (D1,D2) aufweist, die einem zugeordneten Leistungshalbleiterschalter (T1,T4) gegensinnig parallel geschaltet sind, wobei je nach Ansteuerung der Leistungshalbleiterschalter (T1,T4,19) die an einem oder allen Energiespeichern (14) abfallende Spannung oder aber eine Nullspannung zwischen der ersten und der zweiten Anschlussklemme (16,17) erzeugbar ist und wobei die Leistungshalbleiterschaltung einen Überbrückungszweig (18) ausbildet, der zwischen den Potenzialpunkten der ersten und zweiten Anschlussklemme (16,17) liegt,
**dadurch gekennzeichnet, dass** nur die in dem Überbrückungszweig (18) angeordneten Leistungshalbleiterschalter rückwärts leitfähige Leistungshalbleiterschalter (19) sind, die sowohl mittels eines Ansteuersignals in ihrer Durchgangsrichtung ein- und abschaltbar als auch entgegen ihrer schaltbaren Durchgangsrichtung leitfähig sind.

2. Submodul (13) nach Anspruch 1,
**dadurch gekennzeichnet, dass** ein unipolarer Energiespeicher (14) vorgesehen ist, dem eine Reihenschaltung (15) aus ansteuerbaren ein- und abschaltbaren Leistungshalbleiterschaltern mit gleicher Durchlassrichtung parallel geschaltet ist, wobei die erste Anschlussklemme (16) mit einem Pol des Energiespeichers (14) und die zweite Anschlussklemme (17) mit einem zwischen den ansteuerbaren Leistungshalbleiterschaltern (T1,19) liegenden Potenzialpunkt verbunden ist.

3. Submodul (13) nach Anspruch 1,
**dadurch gekennzeichnet, dass** ein erster und ein in Reihe zum ersten Energiespeicher (14) geschalteter zweiter Energiespeicher (22) vorgesehen sind und in dem Überbrückungszweig (18) zwei rückwärts leitfähige Leistungshalbleiterschalter (19) mit gleicher Durchlassrichtung angeordnet sind, wobei der Potenzialpunkt zwischen den rückwärts leitfähigen Leistungshalbleiterschaltern (19) mit dem Potenzialpunkt zwischen dem ersten (14) und dem zweiten Energiespeicher (22) verbunden ist und wobei der Überbrückungszweig (18) über einen ersten (T1) Leistungshalbleiterschalter mit gegensinniger erster Freilaufdiode (D1) mit dem zweiten Energiespeicher (22) und über einen zweiten Leistungshalbleiterschalter (T4) mit gegensinniger Freilaufdiode (D4) mit dem ersten Energiespeicher (14) verbunden ist, so dass der Überbrückungszweig (18) zwischen die nicht rückwärts leitfähigen Leistungshalbleiterschalter (T1,T4) geschaltet ist, wobei alle Leistungshalbleiterschalter (T1,T4,19) in Reihe und mit gleicher Durchlassrichtung angeordnet sind.

4. Submodul (13) nach einem der vorhergehenden Ansprüche,
**dadurch gekennzeichnet, dass** jeder rückwärts leitfähige Leistungshalbleiterschalter (19) so beschaffen ist, dass an diesem eine möglichst geringe Durchlassspannung abfällt.

5. Submodul (13) nach einem der vorhergehenden Ansprüche, **gekennzeichnet durch**
eine Ansteuereinheit zum Ansteuern der ansteuerbaren Leistungshalbleiterschalter (T1,T4,19), wobei die Ansteuereinheit so eingerichtet ist, dass die nicht rückwärts leitfähigen Leistungshalbleiterschalter (T1,T4) im Vergleich zu den rückwärts leitfähigen ansteuerbaren Leistungshalbleiterschaltern (19) langsamer eingeschaltet werden.

6. Submodul (13) nach einem der vorhergehenden Ansprüche 1 bis 4,
**dadurch gekennzeichnet, dass** die nicht im Überbrückungszweig (18) angeordneten Dioden (D1, D4) eine möglichst geringe Speicherladung aufweisen.

7. Mehrfachstufenumrichter (1) mit einem Submodul (13) gemäß einem der vorhergehenden Ansprüche.

## Claims

1. Submodule (13) for a modular multilevel converter (1) comprising
- at least one unipolar energy store (14),
- a first and a second connection terminal (16, 17) and
- a power semiconductor circuit comprising power semiconductor switches (T1, T4, 19) that can be turned on and off by means of a control signal and free-wheeling diodes (D1, D2) connected in parallel with an assigned power semiconductor switch (T1,T4) in the opposite direction, wherein, depending on the control of the power semiconductor switches (T1, T4, 19), the voltage dropping across one or all of the energy stores (14) or else a zero voltage can be generated between the first and the second connection terminals (16,17), and wherein the power semiconductor circuit forms a bridging branch (18) situated between the potential points of the first and second connection terminals (16, 17),
**characterised in that**
only the power semiconductor switches arranged in the bridging branch (18) are reverse conductive power semiconductor switches (19) which can be turned on and off in their through direction by means of a control signal and are also conductive contrary to their switchable through direction.

2. Submodule (13) according to claim 1,
**characterised in that**
a unipolar energy store (14) is provided with which a series circuit (15) comprising controllable power semiconductor switches that can be turned on and off and with an identical forward direction is connected in parallel, wherein the first connection terminal (16) is connected to a pole of the energy store (14) and the second connection terminal (17) is connected to a potential point situated between the controllable power semiconductor switches (T1, 19).

3. Submodule (13) according to claim 1,
**characterised in that**
a first energy store and a second energy store (22), connected in series with respect to the first energy store (14), are provided and two reverse conductive power semiconductor switches (19) with identical forward direction are arranged in the bridging branch (18), wherein the potential point between the reverse conductive power semiconductor switches (19) is connected to the potential point between the first (14) and the second energy store (22), and wherein the bridging branch (18) is connected by a first (T1) power semiconductor switch with a first free-wheeling diode (D1) in the opposite direction to the second energy store (22) and by a second power semiconductor switch (T4) with a free-wheeling diode (D4) in the opposite direction to the first energy store (14), so the bridging branch (18) is switched between the non-reverse conductive power semiconductor switches (T1, T4), wherein all power semiconductor switches (T1,T4,19) are arranged in series and with the same forward direction.

4. Submodule (13) according to any one of the preceding claims, **characterised in that**
each reverse conductive power semiconductor switch (19) is of such a kind that an optimally low forward voltage drops across it.

5. Submodule (13) according to any one of the preceding claims,
**characterised by**
a control unit for controlling the controllable power semiconductor switches (T1,T4,19), wherein the control unit is set up such that the non-reverse conductive power semiconductor switches (T1,T4) can be turned on more slowly than the reverse conductive controllable power semiconductor switches (19).

6. Submodule (13) according to any one of the preceding claims 1 to 4,
**characterised in that**
the diodes (D1,D4) not arranged in the bridging branch (18) have an optimally low storage charge.

7. Multilevel converter (1) comprising a submodule (13) according to any one of the preceding claims.

## Revendications

1. Sous-module (13) pour un convertisseur (1) modulaire à étages multiples comprenant :
- au moins un accumulateur (14) d'énergie unipolaire,
- une première et une deuxième bornes (16, 17) de connexion et
- un circuit à semi-conducteur de puissance qui a un interrupteur (T1, T4, 19) à semi-conducteur de puissance pouvant être fermé et ouvert au moyen d'un signal de commande et des diodes (D1, D2) de roue libre qui sont montées en tête-bêche à un interrupteur (T1, T4) à semi-conducteur de puissance associé, dans lequel,
suivant la commande de l'interrupteur (T1, T4, 19) à semi-conducteur de puissance, la tension chutant aux bornes d'un ou de tous les accumulateurs (14) d'énergie ou une tension nulle entre la première et la deuxième bornes (16, 17) de connexion peut être produite et dans lequel le circuit à semi-conducteur de puissance constitue une branche (18) de shuntage, qui se trouve entre les points de potentiel de la première et de la deuxième bornes (16, 17) de connexion, **caractérisé en ce que**
seuls les interrupteurs à semi-conducteur de puissance montés dans la branche (18) de shuntage sont des interrupteurs (19) à semi-conducteur de puissance conduisant en sens inverse qui tant peuvent être fermés et ouverts au moyen d'un signal de commande dans leur direction passante, qu'également conducteurs dans le sens contraire à leur direction passante commutable.

2. Sous-module (13) suivant la revendication 1,
**caractérisé en ce que**
il est prévu un accumulateur (14) d'énergie unipolaire auquel est monté en parallèle un circuit (15) série composé d'interrupteurs à semi-conducteur de puissance pouvant être activés, fermés et ouverts de même sens passant, la première borne (16) de connexion étant reliée à un pole de l'accumulateur (14) d'énergie et deuxième borne (17) de connexion à un point de potentiel se trouvant entre les interrupteurs (T1, 19) à semi-conducteur de puissance pouvant être activés.

3. Sous-module (13) suivant la revendication 1,
**caractérisé en ce que**
il est prévu un premier et un deuxième accumulateurs (22) d' énergie monté en série avec le premier accumulateur (14) d' énergie et dans la branche (18) shuntage sont montés deux interrupteurs (19) à semi-conducteurs de puissance conducteurs en sens inverse de même sens passant, le point de potentiel entre les interrupteurs (19) à semi-conducteur de puissance conducteurs en sens inverse étant relié au point de potentiel entre le premier (14) et le deuxième accumulateurs (22) d' énergie et la branche (18) de shuntage étant reliée par un premier (T1) interrupteur à semi-conducteur de puissance à une première diode (D1) de roue libre tête bêche au deuxième accumulateur (22) d' énergie et par un deuxième interrupteur (T4) à semi-conducteur de puissance à diode (D4) de roue libre tête bêche au premier accumulateur (14) d' énergie de manière à connecter la branche (18) de shuntage entre les interrupteurs (T1, T4) à semi-conducteur de puissance qui ne sont pas conducteurs en sens inverse, tous les interrupteurs (T1, T4, 19) à semi-conducteur de puissance étant montés en série et en ayant le même sens passant.

4. Sous-module (13) suivant l'une des revendications précédentes,
**caractérisé en ce que**
chaque interrupteur (19) à semi-conducteur de puissance conducteur en sens inverse est tel qu' une tension de passage aussi basse que possible y chute.

5. Sous-module (13) suivant l'une des revendications précédentes,
**caractérisé par**
une unité de commande des interrupteurs (T1, T4, 19) à semi-conducteur de puissance pouvant être activés, l'unité de commande étant telle que les interrupteurs (T1, T4) à semi-conducteur de puissance qui ne conduisent pas en sens inverse sont fermés plus lentement que les interrupteurs (19) à semi-conducteur de puissance pouvant être activés conduisant en sens inverse.

6. Sous-module (13) suivant l'une des revendications précédentes 1 à 4,
**caractérisé en ce que**
les diodes (D1, D4) qui ne sont pas montées dans la branche (18) de shuntage ont une charge de stockage aussi petite que possible.

7. Convertisseur 1 à étages multiples ayant un sous-module (13) sur l'une des revendications précédentes.
